**Europäisches Patentamt**

**European Patent Office**

**Office européen des brevets**

(19)

(11) Veröffentlichungsnummer : **0 006 465**
**B1**

(12)

# EUROPÄISCHE PATENTSCHRIFT

(45) Veröffentlichungstag der Patentschrift :
**30.09.81**

(21) Anmeldenummer : **79101691.8**

(22) Anmeldetag : **01.06.79**

(51) Int. Cl.³ : **H 01 L 29/78, G 11 C 19/28**

(54) **Ladungsgekoppeltes Zwei-Kanal-Halbleiterbauelement.**

(30) Priorität : **30.06.78 US 920935**

(43) Veröffentlichungstag der Anmeldung :
**09.01.80 (Patentblatt 80/01)**

(45) Bekanntmachung des Hinweises auf die Patenterteilung : **30.09.81 Patentblatt 81/39**

(84) Benannte Vertragsstaaten :
**DE FR GB**

(56) Entgegenhaltungen :
**DE - A1 - 2 421 024**
**DE - A1 - 2 820 580**

(73) Patentinhaber : **International Business Machines Corporation**

**Armonk, N.Y. 10504 (US)**

(72) Erfinder : **Jambotkar, Chakrapani Gajanan**
**154 Hosner Mountain Road**
**Hopewell Junction, NY 12533 (US)**

(74) Vertreter : **Busch, Robert, Dipl.-Ing.**
**Schönaicher Strasse 220**
**D-7030 Böblingen (DE)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Imprimerie Jouve, 17, rue du Louvre, 75001 Paris, France

## Ladungsgekoppeltes Zwei-Kanal-Halbleiterbauelement

Die Erfindung betrifft ein ladundsgekoppeltes Zwei-Kanal-Halbleiterbauelement, wie es dem Oberbegriff des Patentanspruchs 1 zu entnehmen ist.

Ladungsgekoppelte Halbleiterbauelemente als solche lassen sich bekanntlich sowohl in datenverarbeitenden Geräten als auch zur Nachrichtenverarbeitung aller Art anwenden. Diesbezüglich wird auf die nachstehend genannten Druckschriften verwiesen : Boyle, W. S. und Smith, G. E., « Charge Coupled Semiconductor Devices », Bell Sys. Tech. J. (April 1970) Seiten 587 bis 593, US-A-3 858 232, US-A-3 761 744, in denen das grundlegende, ladungsgekoppelte Prinzip in Gestalt von Halbleiterbauelementen mit Oberflächenleitungskanal behandelt wird. In einer weiteren US-Patentschrift, nämlich 3 739 240, wird ein ladungsgekoppeltes Halbleiterbauelement mit vergrabenem Leitungskanal vorgestellt, wobei Ladungspakete in Tiefenbereichen des Halbleiters anstatt an dessen Oberfläche auftreten. Abwandlungen dieser vergrabenen Leitungskanalstruktur finden sich außerdem noch in folgenden Druckschriften : US-A-3 858 232 und US-A-3 761 744.

Das ladungsgekoppelte Halbleiterbauelement stellt grundsätzlich eine Anordnung zu serieller Informationsverarbeitung dar und ist deshalb in seiner hierauf anwendbaren Zugriffsdauer sehr viel langsamer als eine übliche Halbleiterspeicheranordnung, die für wahlfreien Zugriff ausgelegt sein kann. Jedoch ist der Vorteil zu verzeichnen, daß sich mit Ladungskopplungsstrukturen höhere Speicherdichten erzielen und erheblich einfachere Bauelemente bereitstellen lassen, so daß hiermit ein sehr viel geringerer Herstellungsaufwand einhergeht als für Bauelemente mit wahlfreiem Speicherzugriff. Dies bedeutet aber, daß allgemein gesehen ladungsgekoppelte Halbleiterspeicherstrukturen ihre Vorteile bei Massenspeicherung zur Geltung bringen können, wo es nicht so sehr auf Zugriffsgeschwindigkeit als auf Kosten pro Speicherstelle ankommt. Jedoch muß andererseits hinwiederum beachtet werden, daß bei Niedrigpreisversionen ladungsgekoppelte Halbleiterbauelementanordnungen bezüglich ihrer Kostenbasis mit gegenwärtig anderweits verfügbaren Techniken im Wettbewerb liegen, wie z.B. Platten- und Magnetbandspeicher ebenso wie mit neuerdings auftretenden Magnetblasenspeichereinrichtungen.

Wenn deshalb eine ladungsgekoppelte Halbleiterbauelementanordnung in einem derartigen Wettbewerb noch Erfolg versprechende Aussichten erlangen soll, dann dürfte von entscheidender Bedeutung sein, Kosten pro Informationsbit auf jede nur erdenkliche Weise herabzudrücken. Wenn davon ausgegangen wird, daß für eine vorgegebene Chipabmessung und festgelegte Herstellungsverfahren die Herstellungskosten angenähert konstant sind, dann kann die wirksamste Weise zur Kostenreduktion nur darin bestehen, daß die Speicherdichte pro Chip entsprechend erhöht wird, mit anderen Worten also, die Anzahl von pro Chipflächeneinheit zu speichernden Informationsbits.

In der bereits erwähnten US-A-3 739 240 ist ein ladungsgekoppeltes Halbleiterbauelement beschrieben, das zwei zueinander im Abstand parallelliegende, vergrabene Leitungskanäle enthält, um voneinander unabhängig zwei Bitfolgen speichern zu können. Falls durchführbar Könnte theoretisch eine derartige Anordnung angenähert für die doppelte Bitdichte zur Informationsspeicherung ausgelegt werden. Tatsächlich scheint aber dieser Vorschlag ein Versuch dahingehend zu sein, ladungsgekoppelte Halbleiter-speicherregister sowohl auf der Vorderals auch auf der Rückseite von Halbleiterscheiben bereitzustellen, um so zwei Speicherregister im gleichen Flächenbereich zu erhalten. Es bestehen jedoch starke Hinweise darauf, daß aufgrund von Nachteile in weder eine entsprechende Produktion aufgenommen worden ist, noch eine praktische Verwendung stattgefunden hat.

Wie es sich sowohl aus oben genanntem als auch aus sonst vorliegendem Stand der Technik ergibt, liegt bisher eine strenge Scheidung zwischen Bipolar- und MOS-Technologie vor. Bipolare Bauelemente gestatten einen Ladungsträgerfluß hinsichtlich beider Leitungstypen, wohingegen MOS-Bauelemente unipolar ausgelegt sind, so daß hier bei Betrieb nur jeweils der Fluß von Ladungsträgern eines einzigen Leitungstyps vorgesehen ist. Es läßt sich demnach speziell festhalten, daß gemäß dem Stand der Technik bei Anwendung der MOS-Technologie Unipolarverhalten zu Grunde liegt.

Bei dieser Sachlage setzt die Erfindung ein, um gegenüber bisher wesentlich verbesserte Anordnungen oben beschriebner Art bereitzustellen, welche im einzelnen gemäß dem Kennzeichen des Patentanspruchs 1 ausgestaltet sind.

Gemäß der Erfindung ergibt sich also eine Struktur, bei der sich gegenüber den Anordnungen gemäß dem Stand der Technik eine doppelte Bitspeicherdichte ergibt, indem grundlegend in Abweichung von der bisher maßgeblichen scharfen Trennung zwischen bipolaren und unipolaren Halbleitertechnologien das bipolare ladungsgekoppelte Zwei-Kanal-Halbleiterbauelement Stromflüsse aufweisen kann, die sowohl Elektronen als auch Löcher betreffen.

Im einzelnen ist bei zwecks Klarlegung der Erfindung nur einem einzigen gezeigten, bevorzugten Ausführungsbeispiel lediglich eine einzelne ladungsgekoppelte Anordnung zur Speicherung und Übertragung zweier getrennter, unabhängig voneinander vorliegender, serienweise auftretender Informationsbitfolgen dargestellt. Demgemäß enthält eine erste Bitfolge eine Reihe von Ladungsträgerpaketen des einen Leitungstyps z.B. Elektronen, die längs eines ersten Leitungskanals im oberflächennahen Bereich der Halbleiters transportiert werden. Eine zweite Bitfolge besteht aus einer Reihe von Ladungsträgerpaketen des entgegengesetzten Leitungstyps, im vorliegenden Fall also Löchern, die in einem zweiten Leitungskanal transportiert werden, der in Tiefenbereichen des Halbleiters vergraben ist, und zwar derart, daß er gegenüber der Bitfolge im oberflächennahen Bereich des Halbleiters unabhängig ist.

Dank der vorliegenden Erfindung kann dann jede Gate-Elektrode zu beiden unterschiedlichen Taktzeiten zwei Potentialmulden bereitstellen, von denen jede Ladungsträgerpakete entgegengesetzten Leitungstyps aufzunehmen vermag. Speziell wird also zur einen Taktzeit eine Potentialmulde erster Art unterhalb der betreffenden Gate-Elektrode im Oberflächenbereich des Halbleiters auftretende Elektroden einfangen, um dann bei der nächsten Taktzeit durch Bilden einer Potentialmulde zweiter Art unter der gleichen Gate-Elektrode im vergrabenen Leitungskanal die in Tiefenbereichen des Halbleiters auftretenden Löcher einzufangen. Es ergibt sich also daraus, daß jede Gate-Elektrode abwechselnd zwei entgegengesetzte Ladungsspeicherstellen bereitstellt, und zwar für Elektronen zur einen Taktzeit und für Löcher zur jeweils folgenden Taktzeit.

Obgleich sich die mit Hilfe der Erfindung ergebende Bitdichte nicht exakt verdoppelt, ist aufgrund zusätzlicher Struktur- und Schaltungsmaßnahmen, um den Erfordernissen des zweiten Leitungskanals Rechnung zu tragen, jedoch die erzielte Bitdichte dank des erfindungsgemäßen bipolaren ladungsgekoppelten Halbleiterbauelements wesentlich höher als mit vergleichbaren Unipolarhalbleiterbauelementen, so daß damit entsprechend auch die Kosten pro Informationsbit wesentlich herabgesetzt sind.

Vorteilhafte Ausgestaltung und Weiterbildung der Erfindung lassen sich den Unteransprüchen entnehmen.

Anhand einer Ausführungsbeispielsbeschreibung wird die Erfindung mit Hilfe der unten aufgeführten Zeichnungen näher erläutert.

Es zeigen :

Fig. 1 einen Ausschnitt der Draufsicht auf eine Anordnung gemäß der Erfindung,

Fig. 2 einen Ausschnitt des Querschnitts durch die Anordnung gemäß der Erfindung, und zwar längs des oberflächennahen Leitungskanals,

Fig. 3 einen Ausschnitt des zur Querschnittsdarstellung nach Fig. 2 senkrecht ausgerichteten Querschnitts,

Fig. 4 einen schematischen Querschnittsausschnitt, in den ein Majoritätsträgerladungspaket innerhalb der vergrabenen Potentialmulde in Tiefenbereichen unterhalb einer ersten Gate-Elektrode und ein Minoritätsträgerladungspaket innerhalb einer oberflächennahen Potentialmulde unterhalb einer zweiten Gate-Elektrode zusammen mit den Auftragungen der Potentialverläufe beider Gate-Elektroden eingezeichnet sind.

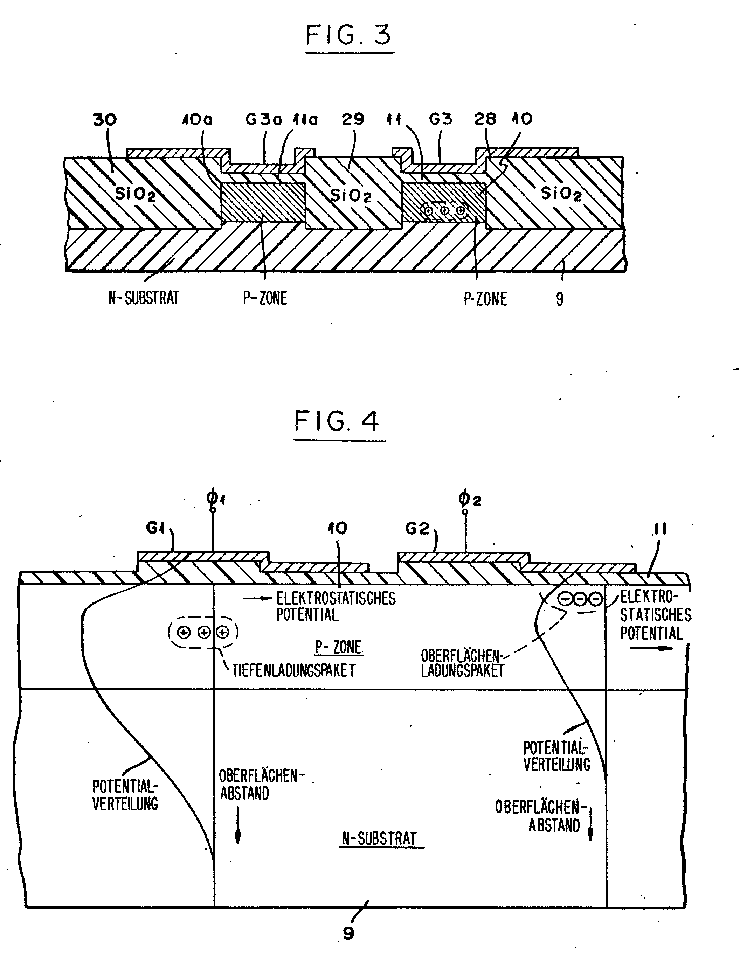

Anhand der zuletzt erwähnten Fig. 4 läßt sich die Betriebsweise der Erfindung am besten beschreiben. Ein N-leitendes Substrat 9 ist mit einer P-Zone 10 bedeckt. Oberhalb dieser P-Zone 10 ist eine dielektrische Schicht 11 aufgebracht, die aus Siliciumdioxid besteht und auf ihrer Oberfläche die Gate-Elektroden trägt, von denen hier nur zwei, nämlich G1 und G2, gezeigt sind.

Die P-Zone 10 ist in üblicherweise in Rückwärtsrichtung vorgespannt, so daß sich eine Verarmungszone ausbildet, die einen vergrabenen Leitungskanal darstellt, längs dem Ladungspakete bestehend aus Löcher auftreten und in bekannter Art und Weise weiterverschoben werden können. Eines dieser vergrabenen Ladungspakete ist in der Darstellung nach Fig. 4 durch eine gestrichelt gezeichnete Umrandung dreier Kreise, jeweils mit Pluszeichen versehen, als Hinweis auf Löcher angedeutet. Dies so dargestellte Tiefenladungspaket befindet sich in einer vergrabenen Potentialmulde im Tiefenbereich der P-Zone unterhalb der ersten Gate-Elektrode G1.

Unterhalb der zweiten Gate-Elektrode G2 im oberflächennahen Bereich der P-Zone 10 ist ein Elektronenladungspaket, das sich auch als Oberflächenladungspaket bezeichnen läßt, innerhalb einer zweiten Potentialmulde angedeutet, und zwar durch eine gestrichelt gezeichnete Umhüllung, die Kreise mit Minuszeichen zur Andeutung der Elektronen umschließt.

Zum Betrieb der erfindungsgemäßen Anordnung, d.h. zur Verschiebung der Ladungspakete, werden bekanntlich Taktimpulse entsprechend unterschiedlicher Phasenlage, bezeichnet mit $\varnothing 1$ und $\varnothing 2$, an die betreffenden Gate-Elektroden G1 und G2 angelegt. Das durch die an die Gate-Elektrode G1 angelegte Taktspannung $\varnothing 1$ hervorgerufene Potential ist in seinem Verfauf unterhalb dieser Gate-Elektrode G1 angedeutet, ebenso wie der Potentialverlauf aufgrund der an die Gate-Elektrode G2 angelegten Taktspannung $\varnothing 2$ unterhalb dieser Elektrode aufgetragen ist. Die jeweilige Abszisse beider Potentialverläufe erstreckt sich, wie durch den jeweiligen Pfeil mit der Bezeichnung Oberflächenabstand angedeutet, nach unten, so daß sich ein Potentialverteilungsverlauf in Abhängigkeit vom Oberflächenabstand im Halbleiter ergibt. Die jeweilige Ordinate dieser Potentialverteilungen erstreckt sich in Richtung der jeweils mit « elektrostatisches Potential » bezeichneten, horizontal ausgerichteten Pfeile.

Im Ansprechen auf zeitgerecht an die Gate-Elektroden, wie G1 und G2, angelegte Taktspannungen zweier unterschiedlicher Phasenlagen $\varnothing 1$ und $\varnothing 2$ werden also die Tiefenladungspotentialmulden mit den Löchern enthaltenden Tiefenladungspaketen längs des vergrabenen Leitungskanals von Gate-Bereich zu Gate-Bereich verschoben, so daß sich bei Informationsbitdarstellung durch derartige Ladungspakete eine sich von links nach rechts ausbreitende Datenbitfolge ergibt, während sich gleichzeitig die Oberflächenladungspotentialmulden mit den hierin enthaltenen, Elektronen aufweisenden Oberflächenladungspaketen aufeinanderfolgend ebenfalls von Gate-Bereich zu Gate-Bereich längs des in der P-Zone 10 ausgebildeten Leitungskanal ausbreiten, so daß sich eine zweite, von rechts nach links verschiebende Datenbitfolge ergibt. Der somit auftretende gleichzeitig Fluß zweier getrennter und voneinander unabhängiger Datenbitfolgen führt ersichtlich dazu, daß die Speicherbitdichte der Ladungskopplungsanordnung gemäß der Erfindung, gegenüber gleichen Anordnungen gemäß dem Stand der Technik, nahezu verdoppelt ist.

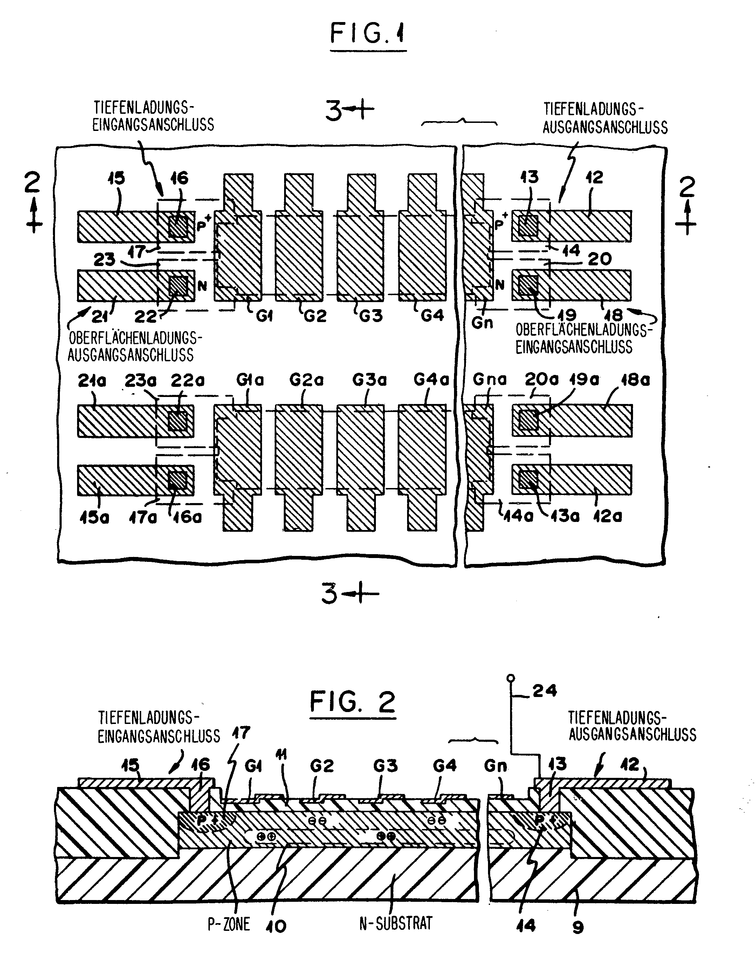

Aus den Darstellungen nach den Fig. 1 bis 3 lassen sich die Einzelheiten der erfindungsgemäßen Anordnung entnehmen. Hierin wird ein Teil eines in monolithisch integrierter Halbleitertechnik ausgebildeten Schieberegisters mit zwei benachbarten Serienleitungskanälen dargestellt, wobei jeder Leitungskanal ein Serienschieberegister darstellt. Es versteht sich jedoch von selbst, daß sich die Erfindung leicht in parallel-abschnittsweisem Aufbau realisieren läßt, so daß eine Serein-Parallel-Serien-Speicherkonfiguration vorliegt.

Einer der Serienschieberegisterabschnitte ist im oberen Teil der Fig. 1 dargestellt und soll anschließend im einzelnen erläutert werden. Der andere Serienschieberegisterabschnitt stellt eine spiegelbildliche Wiedergabe des ersten Schieberegisterabschnitts dar und wird im unteren Teil der Fig. 1 gezeigt. Entsprechende Elemente beider Schieberegister enthalten gleiche Bezugszeichen, wobei lediglich im zweiten Schieberegister den Bezugszeichen jeweils ein Suffix a angehängt ist.

Beide Schieberegister befinden sich in einem Halbleiter, in Form eines Substrats 9 aus N-leitendem Material, welches an seiner Oberfläche eine Diffusionszone in Form der P-Zone 10 aufweist. Oberhalb der P-Zone 10 liegt eine aus Siliciumdioxid gebildete dielektrische Schicht 11. Letztere trägt in Hintereinanderanordnung die Gate-Elektroden G1, G2, G3, G4, Gn in entsprechenden Vertiefungen der Siliciumdioxidschicht. Rechter Hand jedes Schieberegisters befindet sich ein Tiefenladungsausgangskanal, der die Drain-Elektrode für die aus Löchern bestehenden Ladungspakete darstellt. Dieser Ausgangskanal enthält ein metallisches Anschlußstück 12, das mit einem sich nach unten durch die dielektrische Schicht 11 hindurch erstreckenden Teil 13 in Verbindung steht, das seinerseits in Kontakt mit einer P$^+$-Diffusionszone ist. Letztere ist in der P-Zone 10 selbst eingebettet.

Am linken Ende jedes Schieberegisters befindet sich ein Tiefenladungseingangskanal, der als Source-Elektrode für die Löcher enthaltenden Ladungspakete dient. Dieser Eingangskanal enthält ein Metallanschlußstück 15, das mit einem sich durch die isolierende Siliciumdioxidschicht 11 hindurch erstreckenden Teil 16 in Verbindung steht, so daß hierdurch eine innerhalb der P-Zone 10 gebildete zweite P$^+$-Diffusionszone 17 kontaktiert wird.

Rechter Hand jedes Schieberegisters befindet sich außerdem ein Oberflächenladungseingangskanal, der als Source-Elektrode für die Elektronen enthaltenden Ladungspakete dient. Dieser Einganskanal besteht aus einem Metallanschlußstück 18, das mit einem sich durch den Siliciumdioxidfilm 11 hindurch erstreckenden Teil 19 in ähnlicher Weise in Verbindung steht, wie das Metallanschlußstück 12 mit Teil 13. Jedoch erstreckt sich der mit dem Metallanschlußstück 18 in Verbindung stehende Teil 19 zu einer Diffusionszone 20, die sich insofern von der diffusionszone 14 unterscheidet, als diese Zone 20 N-leitend ist und innerhalb der P-Zone 10 der P$^+$-Diffusionszone 14, wie in Fig. 3 gezeigt, benachbart angeordnet ist.

Linker Hand jedes Schieberegisters befindet sich ein Oberflächenladungsausgangskanal, der als Drain-Elektrode für die Elektronen enthaltenden Ladungspakete dient. Dieser Ausgangskanal ist in seinem Aufbau mit dem Oberflächenladungseingangskanal gleich und enthält ebenfalls ein Metallanschlußstück 21 mit daran anschließendem, sich durch den Siliciumdioxidfilm 11 hindurch erstreckendem Teil 22, so daß sich ein leitender Kontakt mit einer N-Diffusionszone 23 ergibt, die ihrerseits in die P-Zone 10, benachbart zur P$^+$-Diffusionszone 17, eingebracht ist.

Aus Fig. 3 läßt sich ersehen, daß der Siliciumdioxidfilm 11 nach unten verdickte Bereiche 28, 29, 30 aufweist, um so bedeutsame Aufgaben zu übernehmen. Als erstes verhindern diese Bereiche, daß die aus Elektronen bestehende Oberflächenladung der P-Zone 10 zum N-leitenden, an der höchsten positiven Spannung liegenden Substrat 9 entweichen kann. Zum zweiten isolieren die verdickten Bereiche im Siliciumfilm 11 benachbarte Leitungskanäle voneinander, die im bevorzugten Ausführungsbeispiel als benachbart liegende Serienschieberegisterabschnitte dargestellt sind. So erstreckt sich beispielsweise der verdickte Bereich 29 des Siliciumdioxidfilms 11 zwischen dem Kanal des ersten Serienschieberegisterabschnitts und dem benachbart liegenden Kanal des zweiten Serienschieberegisterabschnitts, womit beide benachbart zueinander angeordnete Leitungskanäle also gegenseitig isoliert voneinander sind.

Um einen vergrabenen Leitungskanal innerhalb der P-Zone 10 bereitzustellen, muß letzterer entsprechend an Ladungsträgern verarmt sein. Dies wird in üblicher Weise durch Anlegen einer negativen Vorspannung an die Anschlußleitung 24 (Fig. 2) des Metallanschlußstücks 12 des Tiefenladungsausgangskanals erreicht.

Die Betriebsweise der in Fig. 1 bis 3 gezeigten Struktur ergibt sich aus oben stehender Beschreibung der Erfindung anhand der Fig. 4, so daß an dieser Stelle eine summarische Abhandlung ausreicht. Eine erste serielle Datenbitfolge in Form entsprechender Ladungen tritt in einen seriellen Schieberegisterabschnitt über Oberflächenladungseingangskanal 18, 19, 20 ein und breitet sich in Form einer Serie von Elektronen enthaltenden Ladungspaketen von rechts nach links aus, und zwar längs der Oberfläche der P-Zone 10. Diese Elektronen enthaltenden Ladungspakete werden von Potentialmulde zu Potentialmulde weitergeschoben sowie geeignete Taktspannungen unterschiedlicher Phasenlage in zeitlicher Aufeinanderfolge an die Gate-Elektroden G1, G2, G3, G4, Gn in allgemein üblicher Weise angelegt werden. Diese serielle Folge von Elektronen enthaltenden Oberflächenladungspaketen wird dann aus dem Schieberegisterabschnitt über Oberflächenladungsausgangskanal 21, 22, 23 herausgeschoben.

Gleichzeitig mit der Folge von Elektronen enthaltenden Ladungspaketen längs der Oberfläche der P-Zone 10 fließt eine zweite serielle Datenbitfolge in entgegengesetzter Richtung von links nach rechts. Diese zweite Datenbitfolge wird, wie gesagt, durch Löcher enthaltende Tiefenladungspakete dargestellt. Diese Datenbitfolge tritt in den seriellen Schieberegisterabschnitt über Tiefenladungseingangskanal 15, 16, 17 ein, so daß die sich dann ergebenden, Löcher enthaltenden Ladungspakete seriell von Potentialmulde zu Potentialmulde längs der im Tiefenbereich der P-Zone 10 gebildeten vergrabenen Ladungsträgerverarmungszone im Ansprechen auf die Taktspannungen unterschiedlicher Phasenlage weiter verschoben werden. Diese serielle Folge von Löcher enthaltenden Ladungspaketen wird dann dem seriellen Schieberegisterabschnitt über Tiefenladungsausgangskanal 12, 13, 14 entnommen.

## Ansprüche

1. Ladungsgekoppeltes Zwei-Kanal-Halbleiterbauelement mit mehreren, Schieberegister bildenden Leitungskanälen in einem Halbleiter, welche zwischen Eingangs- und Ausgangsanschlüssen unterhalb von isoliert auf der Halbleiteroberfläche angebrachten, mit Taktsignalen beaufschlagbaren Gate-Elektroden verlaufen, die in Gate-Vertiefungen einer auf dem Halbleiter aufgebrachten dielektrischen Schicht angeordnet sind, dadurch gekennzeichnet, daß ein eine Zone des ersten Leitfähigkeittyps bildendes Halbleitersubstrat (9) in den dür die Schieberegister vorgesehenen Bereichen mit Halbleiterzonen (10) vom zweiten Leitfähigkeitstyp bedeckt ist, indem die übrigen Bereiche des Halbleitersubstrats (9) zusammen mit den Halbleiterzonen vom zweiten Leitfähigkeitstyp von der dielektrischen Schicht (11) überzogen sind, daß in den Eingangs- und in den den Ausgangsanschlüssen benachbarten Bereichen jeder Halbleiterzone (10) vom zweiten Leitfähigkeitstyp sich bis unterhalb der jeweils benachbart angeordneten, ersten (G1) bzw. letzten Gate-Elektrode (Gn) erstreckend und jeweils einander über die Längsrichtung der betreffenden Halbleiterzone (10) gesehen gegenüberliegend, je eine erste Anschlußzone (14 u. 17 und je eine zweite Anschlußzone (20 und 23) jeweils als Ein- bzw. Ausgang des mit der betreffenden kontaktierten Halbleiterzone (10) gebildeten Schieberegisters in die Zonen (10) vom zweiten Leitfähigkeitstyp angebracht sind, wobei die ersten Anschlußzonen (14 und 17) zwar ebenfalls vom zweiten Leitfähigkeitstyp, jedoch entartet dotiert sind, und die zweiten Anschlußzonen (20 und 23) vom ersten Leitfähigkeitstyp sind und daß an eine (14) der ersten Anschlußzonen (14 und 17) über einen Elektrodenanschluß (24) eine Sperrvorspannung anlegbar ist.

2. Anordnung nach Anspruch 1, dadurch gekennzeichnet, daß die Halbleiterzonen (10) vom zweiten Leitfähigkeitstyp jeweils auf im Halbleitersubstrat (9) ausgebildeten Sockeln liegen, so daß die dielektrische Schicht (11) in ihren demgemäß verdickten Bereichen (28, 29, 30) jeweils in Richtung der Verlängerung der Kanten der über den Sockeln liegenden Halbleiterzonen (10) vom zweiten Leitfähigkeitstyp in das Substrat (9) hinein- ragt und daß die Gate-Elektroden (G1 bis Gn) mit außerhalb der Gate-Vertiefungen auf der dielektrischen Schicht (11) liegenden Metallisierungen als Gate-Anschlüssen in Verbindung stehen.

3. Anordnung nach Anspruch 1 und Anspruch 2, dadurch gekennzeichnet, daß die dielektrische Schicht (11) aus Siliciumdioxid und daß das Halbleitersubstrat (9) vom N-Leitfähigkeitstyp ist.

4. Anordnung nach den Ansprüchen 2 und 3, dadurch gekennzeichnet, daß die Gate-Anschlußmetallisierungen auf der dielektrischen Schicht (11) nur auf einer Seite der jeweiligen Gate-Vertiefung angeordnet sind.

## Claims

1. Charge-coupled dual channel semiconductor structure with several conductive channels forming shift registers in a semiconductor, extending between input and output terminals beneath gate electrodes isolated on the semiconductor surface and to be energized with clock signals, which gate electrodes are arranged in gate recesses of a dielectric layer on the semiconductor, characterized in that a semiconductor substrate (9) forming a zone of the first conductivity type is covered in the regions for the shift registers with semiconductor zones (10) of the second conductivity type, in that the remaining regions of the semiconductor substrate (9), together with the semiconductor zones of the second conductivity type are coated with the dielectric layer (11), in that in the input regions and the regions adjacent to the output terminals of each semiconductor zone (10) of the second conductivity type, extending to below the respective adjacent first (G1) or last gate electrode (Gn) and facing each other seen over the longitudinal direction of the respective semiconductor zone (10), one respective first terminal zone (14 and 17) and one respective second terminal zone (20 and 23) are provided as input or output of the shift register formed with the respective contacted semiconductor zone (10), in the zones (10) of the second conductivity type, the first terminal zones (14 and 17), although of the second conductivity type, being of a degenerate impurity concentration, and the second terminal zones (20 and 23) being of the first conductivity type, and in that a backward biasing is applicable to one (14) of the first terminal zones (14 and 17) via an electrode terminal (24).

2. Arrangement as claimed in Claim 1, characterized in that the semiconductor zones (10) of the second conductivity type are each provided on bases in the semiconductor substrate (9) so that the dielectric layer (11), in its accordingly thickened regions (28, 29, 30), in the direction of the edge extension of the semiconductor zones (10) of the second conductivity type over the bases protrudes into the substrate (9), and that the gate electrodes (G1 to Gn) are connected to metallizations as gate terminals provided outside the gate recessions on the dielectric layer (11).

3. Arrangement as claimed in Claim 1 and Claim 2, characterized in that the dielectric layer (11) consists of silicon dioxide, and that the semiconductor substrate (9) is of the N-conductivity type.

4. Arrangement as claimed in Claims 2 and 3, characterized in that the gate contact metallizations are arranged on the dielectric layer (11) only on one side of the respective gate recess.

**Revendications**

1. Dispositif semi-conducteur à charges couplées à courant de porteurs double du genre comportant plusieurs canaux conducteurs formant des registres à décalage dans un corps semi-conducteur, disposés entre des bornes d'entrée et de sortie situées en dessous de portes isolées, à la surface du dispositif et commandées par des signaux d'horloge ; lesdites portes sont disposées dans des creux pratiqués dans une couche diélectrique formée à la surface du dispositif semi-conducteur ; ce dispositif est caractérisé en ce qu'un substrat semi-conducteur (9) d'un premier type de conductivité est recouvert avec des régions semi-conductrices (10) du second type de conductivité dans les zones prévues pour constituer les registres à décalage ; en ce que les régions restantes du substrat semi-conducteur (9) et des régions semi-conductrices du second type de conductivité sont recouvertes par une couche diélectrique (11) ; en ce que dans les portions de chaque région semi-conductrice (10) du second type de conductivité, voisines des bornes d'entrée et de sortie, sont disposées une première région de connexion (14 et 17) et une seconde région de connexion (20 et 23) fonctionnant comme entrée et sortie du registre à décalage formé dans les régions (10) du second type de conductivité, ces première et seconde régions s'étendant jusqu'en dessous de la première (G1) ou la dernière (Gn) porte adjacente et se faisant face, selon le sens longitudinal des régions semi-conductrices (10), lesdites premières régions de contact (14 et 17) étant du même type de conductivité mais dopées de façon dégénérée, et lesdites secondes régions de contact (20 et 23) étant du premier type de conductivité, et enfin en ce qu'une tension de polarisation de blocage peut être appliquée à l'une des premières régions de connexion (14 et 17) à travers une connexion d'électrode (24).

2. Dispositif selon la revendication 1 caractérisé en ce que les régions semi-conductrices (10) du second type de conductivité sont chacune disposées à des emplacements du substrat semi-conducteur (9) de sorte que la couche diélectrique (11) pénètre dans le substrat (9) dans le sens du prolongement des bords des régions semi-conductrices (10) du second type de conductivité en formant des régions épaissies (28, 29, 30), et en ce que les portes (G1 à Gn) sont connectées, sous forme de connexion de porte, avec des métallisations situées à l'extérieur des creux de porte de la couche diélectrique (11).

3. Dispositif selon la revendication 1 et la revendication 2, caractérisé en ce que la couche diélectrique (11) est à base de dioxyde de silicium et que le substrat semi-conducteur (9) est du type de conductivité N.

4. Dispositif selon l'une des revendications 2 et 3, caractérisé en ce que les métallisations de connexion de porte sont disposées sur un seul côté des creux de porte respectifs sur la couche diélectrique (11).

## FIG. 1

TIEFENLADUNGS-
EINGANGSANSCHLUSS

TIEFENLADUNGS-
AUSGANGSANSCHLUSS

3 ‒┼

15    16          $P^+$    G1  G2  G3  G4

23  17

21  22    N

OBERFLÄCHENLADUNGS-
AUSGANGSANSCHLUSS

13  12

14  20

Gn    19  48

OBERFLÄCHENLADUNGS-
EINGANGSANSCHLUSS

24a  23a  22a   G1a  G2a  G3a  G4a      Gna  20a  19a  18a

15a  17a  16a

44a  13a  42a

3 ‒┼

## FIG. 2

24

TIEFENLADUNGS-
EINGANGSANSCHLUSS

TIEFENLADUNGS-
AUSGANGSANSCHLUSS

15    16   17  G1  11  G2    G3    G4    Gn    13    42

$P^+$

$P^+$

P-ZONE    10    N-SUBSTRAT    44    9

# FIG. 3

30   10a   G3a 11a   29   11   G3   28   10

SiO₂          SiO₂          SiO₂

N-SUBSTRAT     P-ZONE          P-ZONE   9

# FIG. 4

Φ₁          Φ₂

G1          10          G2          11

ELEKTROSTATISCHES
POTENTIAL

(⊕ ⊕ ⊕)   P-ZONE   ⊖⊖⊖   ELEKTRO-
STATISCHES
POTENTIAL

TIEFENLADUNGSPAKET          OBERFLÄCHEN-
LADUNGSPAKET

POTENTIAL-
VERTEILUNG

POTENTIAL-
VERTEILUNG          OBERFLÄCHEN-
ABSTAND

OBERFLÄCHEN-
ABSTAND          N-SUBSTRAT

9